(19) Europäisches Patentamt
European Patent Office
Office européen des brevets

(11) **EP 2 472 626 A1**

(12) **EUROPEAN PATENT APPLICATION**
published in accordance with Art. 153(4) EPC

(43) Date of publication:
**04.07.2012 Bulletin 2012/27**

(21) Application number: **10811682.3**

(22) Date of filing: **09.08.2010**

(51) Int Cl.:
*H01L 51/42* (2006.01)          *H01L 27/146* (2006.01)
*H01M 14/00* (2006.01)

(86) International application number:
**PCT/JP2010/063470**

(87) International publication number:
**WO 2011/024632 (03.03.2011 Gazette 2011/09)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **28.08.2009 JP 2009197651
19.01.2010 JP 2010008791**

(71) Applicant: **Sony Corporation
Tokyo 108-0075 (JP)**

(72) Inventors:
• **LUO Wei
Tokyo 108-0075 (JP)**

• **YAMADA Seiji
Tokyo 108-0075 (JP)**
• **GOTO Yoshio
Tokyo 108-0075 (JP)**
• **TOKITA Yuichi
Tokyo 108-0075 (JP)**

(74) Representative: **Müller - Hoffmann & Partner
Patentanwälte
Innere Wiener Strasse 17
81667 München (DE)**

(54) **LIQUID-UNCONTACTING ALL-SOLID-STATE PROTEIN PHOTOELECTRIC CONVERSION ELEMENT AND PROCESS FOR PRODUCTION THEREOF, AND ELECTRONIC DEVICE**

(57) A non-wetted all solid protein photoelectric conversion device that is able to be operated without existence of a liquid such as water inside and outside of the device and a method of manufacturing the same are provided. The non-wetted all solid protein photoelectric conversion device has a structure in which a solid protein layer 13 composed of an electron transfer protein is sandwiched between an electrode 11 and an electrode 12. The solid protein layer 13 is immobilized onto the electrodes 11 and 12. The solid protein layer 13 does not contain a liquid such as water. The solid protein layer 13 is composed of a monomolecular film or a multimolecular film of the electron transfer protein.

FIG. 1

**EP 2 472 626 A1**

**Description**

Technical Field

The present invention relates to a non-wetted all solid protein photoelectric conversion device, a method of manufacturing the same, and an electronic device using the non-wetted all solid protein photoelectric conversion device.

Background Art

Proteins demonstrate complicated functions though their size is significantly small (from 2 to 10 nm both inclusive). Thus, the proteins are promising as a next-generation functional device replacing a semiconductor device. In the past, as a photoelectric conversion device using a protein, a photoelectric conversion device using a protein immobilized electrode in which zinc-substituted cytochrome c (obtained by substituting iron as a central metal of a prosthetic group heme of horse heart cytochrome c with zinc) is immobilized onto a gold electrode has been proposed (see Patent document 1). It is disclosed that a photocurrent is obtained from the protein immobilized electrode.

Prior art documents

Patent documents

Patent document 1: Japanese Unexamined Patent Application Publication No. 2007-220445

Patent document 2: Japanese Unexamined Patent Application Publication No. 2009-21501

Non-patent document

Non-patent document 1: Tokita Y. and four others, J. Am. Chem. Soc. 130, 5302 (2008)

Summary of the Invention

Proteins are biological materials. Thus, it is a general idea that, in a device using a protein, the protein should be retained in a liquid containing water. In practice, for example, in an experiment in which a photocurrent is obtained from a protein immobilized electrode in the photoelectric conversion device proposed in Patent document 1, the protein immobilized electrode and a counter electrode are soaked in a phosphoric acid buffer aqueous solution containing an electrolyte.
However, if water exists in the photoelectric conversion device using a protein, or the photoelectric conversion device is retained in the liquid containing water, there are problems such as possibility of electric shock and difficulty to secure strength. Further, there are heat denaturation of the protein and protein damage caused by radical generation of dissolved oxygen in the water that might occur due to presence of water. Accordingly, a large voltage is not able to be applied to the device, which limits operation of the device.
Therefore, it is an object of the present invention to provide a non-wetted all solid protein photoelectric conversion device free of the foregoing defects due to its operability without presence of a liquid such as water inside or outside of the device and a method of manufacturing the same.
It is another object of the present invention to provide an electronic device using the foregoing non-wetted all solid protein photoelectric conversion device.
The inventors devoted themselves to their studies. As a result, they found a fact that defies existing common sense in which, in a device using a protein, the protein should be retained in a liquid containing water. Specifically, they have firstly realized a protein photoelectric conversion device using an electron transfer protein but being capable of being operated without presence of water inside or outside of the device, and have originated the present invention.
That is, to resolve the foregoing problems, the present invention is a non-wetted all solid protein photoelectric conversion device that has a structure in which a solid protein layer composed of an electron transfer protein is sandwiched between a first electrode and a second electrode.
Further, the present invention is a method of manufacturing a non-wetted all solid protein photoelectric conversion device including: attaching a solution containing an electron transfer protein to at least part of a first electrode; forming a solid protein layer composed of the electron transfer protein by drying the first electrode to which the solution is attached and removing a solvent of the solution; and forming a second electrode on the solid protein layer.

Further, the present invention is an electronic device that has a non-wetted all solid protein photoelectric conversion device having a structure in which a solid protein layer composed of an electron transfer protein is sandwiched between a first electrode and a second electrode.

In the present invention, the solid protein layer means a lamellar solid composed of electron transfer protein assembly not containing a liquid such as water. Further, "non-wetted" of the non-wetted all solid protein photoelectric conversion device means that the device is used in a state that the inside and outside of the protein photoelectric conversion device are not contacted with a liquid such as water. Further, "all solid" of the non-wetted all solid protein photoelectric conversion device means that all regions of the device do not contain a liquid such as water.

The solid protein layer may be composed of a monomolecular film of the electron transfer protein or a multimolecular film composed of two or more layers of the electron transfer protein. The solid protein layer is typically immobilized onto the first electrode and the second electrode directly. As a conductive material used for the first electrode and the second electrode, for example, a metal, conductive glass, a conductive oxide, a conductive polymer, and the like can be used. The surface shape of the first electrode and the second electrode may be an optional shape such as a concave face, a convex face, and a convexoconcave face. The solid protein layer is able to be easily immobilized onto a face of any shape. A conductive material used for the first electrode may be the same as or may be different from a conductive material used for the second electrode. In the case where light enters the solid protein layer through at least one of the first electrode and the second electrode, at least one of the first electrode and the second electrode is a transparent electrode made of a material transparent to visible light.

As the electron transfer protein composing the solid protein layer, an electron transfer protein containing metal or an electron transfer protein not containing metal (metal free) can be used. The metal contained in the electron transfer protein is suitably a transition metal having an electron in a higher energy orbit equal to or greater than d orbit (for example, zinc, iron, or the like).

In the method of manufacturing a non-wetted all solid protein photoelectric conversion device, typically, the solvent of the solution is removed by drying the first electrode to which the solution containing the electron transfer protein is attached at temperature lower than denaturation temperature of the electron transfer protein. To attach the solution containing the electron transfer protein, the first electrode may be coated with the solution, the solution may be sprayed onto the first electrode, or the first electrode may be soaked in the solution. The solution containing the electron transfer protein is typically a buffer solution containing water as a solvent. As a method of forming the solid protein layer, various methods can be used, and a method is selected as appropriate. For example, a falling drop method, a spin coat method, a dip method, a spray method, or the like can be used. After the solid protein layer is formed on the first electrode, as a method of forming the second electrode on the solid protein layer, a sputtering method or a vacuum evaporation method is suitably used, though not limited thereto.

The non-wetted all solid protein photoelectric conversion device is, for example, an optical switching device, an optical sensor, an image capturing device, or the like. The optical sensor is able to be used for various purposes such as detecting an optical signal, and is applicable to an artificial retina or the like. Examples of the electronic device include various devices that use a photoelectric conversion device. Specific examples thereof include an electronic device using an optical switching device or an optical sensor.

In the present invention structured as described above, since the photoelectric conversion device includes the solid protein layer composed of the electron transfer protein, and is a non-wetted all solid type, there is no possibility that electric shock occurs, and strength is easily secured. Further, since water does not exist inside of the photoelectric conversion device, heat denaturation, radical damage, decay, or the like of the electron transfer protein that might be generated due to existence of water are eliminated.

According to the present invention, a non-wetted all solid protein photoelectric conversion device capable of being operated without existence of a liquid such as water inside or outside of the device is able to be realized, and an optical switching device, an optical sensor, an image capturing device, and the like are able to be realized by using the non-wetted all solid protein photoelectric conversion device. The non-wetted all solid protein photoelectric conversion device is able to be mounted on an electronic device in which the existence of a liquid such as water is problematic. By using the non-wetted all solid protein photoelectric conversion device, a superior electronic device is able to be realized.

Brief Description of Drawings

[FIG. 1] FIG. 1 is a cross sectional view illustrating a non-wetted all solid protein photoelectric conversion device according to an embodiment of the present invention.
[FIG. 2] FIG. 2 is a cross sectional view illustrating an enlarged main section of the non-wetted all solid protein photoelectric conversion device illustrated in FIG. 1.
[FIG. 3] FIG. 3 is a schematic diagram illustrating operation of the non-wetted all solid protein photoelectric conversion device according to the embodiment of the present invention.

[FIG. 4] FIG. 4 is a plain view for explaining a manufacturing method of a non-wetted all solid protein photoelectric conversion device of Example 1 according to the present invention.

[FIG. 5] FIG. 5 is a plain view for explaining the manufacturing method of the non-wetted all solid protein photoelectric conversion device of Example 1 according to the present invention.

[FIG. 6] FIG. 6 is a cross sectional view illustrating a cross sectional structure of the non-wetted all solid protein photoelectric conversion device of Example 1 according to the present invention.

[FIG. 7] FIG. 7 is a schematic diagram illustrating a measurement result of photocurrent action spectrums of the non-wetted all solid protein photoelectric conversion device of Example 1 according to the present invention.

[FIG. 8] FIG. 8 is a schematic diagram illustrating a measurement result of background current-voltage characteristics of the non-wetted all solid protein photoelectric conversion device of Example 1 according to the present invention.

[FIG. 9] FIG. 9 is a schematic diagram illustrating a measurement result of current-voltage characteristics of the non-wetted all solid protein photoelectric conversion device of Example 1 according to the present invention.

[FIG. 10] FIG. 10 is a schematic diagram illustrating a measurement result of photocurrent action spectrums of the non-wetted all solid protein photoelectric conversion device of Example 1 according to the present invention and a liquid type protein photoelectric conversion device.

[FIG. 11] FIG. 11 is a schematic diagram obtained by standardizing the measurement result of the spectrums of the non-wetted all solid protein photoelectric conversion device of Example 1 according to the present invention and the liquid type protein photocurrent conversion device so that a peak value of the photocurrent is 1.

[FIG. 12] FIG. 12 is a schematic diagram illustrating a measurement result of light degradation curves of the non-wetted all solid protein photoelectric conversion device of Example 1 according to the present invention and the liquid type protein photoelectric conversion device.

[FIG. 13] FIG. 13 is a schematic diagram obtained by standardizing the measurement result of the light degradation curves of the non-wetted all solid protein photoelectric conversion device of Example 1 according to the present invention and the liquid type protein photoelectric conversion device so that a peak value of the photocurrent at the time of the start of irradiation becomes 1.

[FIG. 14] FIG. 14 is a schematic diagram illustrating a measurement result of frequency response of the liquid type protein photoelectric conversion device.

[FIG. 15] FIG. 15 is a schematic diagram illustrating a measurement result of frequency response of the non-wetted all solid protein photoelectric conversion device of Example 1 according to the present invention.

[FIG. 16] FIG. 16 is a schematic diagram illustrating a measurement result of a photocurrent action spectrum of the non-wetted all solid protein photoelectric conversion device of Example 1 according to the present invention.

[FIG. 17] FIG. 17 is a schematic diagram illustrating a measurement result of light degradation curves of the non-wetted all solid protein photoelectric conversion device of Example 1 according to the present invention.

[FIG. 18] FIG. 18 is a schematic diagram illustrating a measurement result of a photocurrent action spectrum of the non-wetted all solid protein photoelectric conversion device of Example 1 according to the present invention.

[FIG. 19] FIG. 19 is a cross sectional view illustrating a cross sectional structure of a non-wetted all solid protein photoelectric conversion device of Example 2 according to the present invention.

[FIG. 20] FIG. 20 is a schematic diagram illustrating a measurement result of a photocurrent action spectrum of the non-wetted all solid protein photoelectric conversion device of Example 2 according to the present invention.

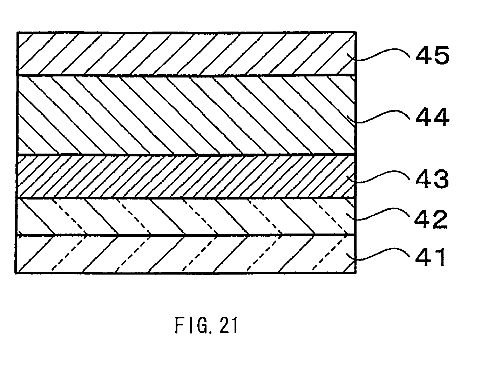

[FIG. 21]FIG. 21 is a cross sectional view illustrating a cross sectional structure of a non-wetted all solid protein photoelectric conversion device of Example 3 according to the present invention.

Best Mode(s) for Carrying Out the Invention

An embodiment for carrying out the present invention (hereinafter referred to as "embodiment") will be hereinafter described.

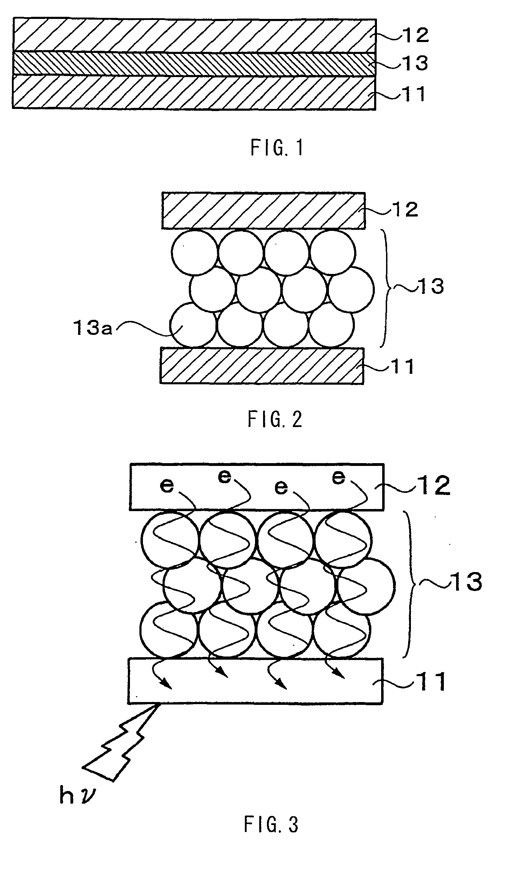

FIG. 1 illustrates a non-wetted all solid protein photoelectric conversion device according to the embodiment.

As illustrated in FIG. 1, the non-wetted all solid protein photoelectric conversion device has a structure in which a solid protein layer 13 composed of an electron transfer protein is sandwiched between an electrode 11 and an electrode 12. The solid protein layer 13 is immobilized onto the electrodes 11 and 12. The solid protein layer 13 is typically immobilized onto the electrodes 11 and 12 directly. However, as necessary, an intermediate layer not containing a liquid such as water may be provided between the solid protein layer 13 and the electrodes 11 and 12. The solid protein layer 13 does not contain a liquid such as water. The solid protein layer 13 is composed of a monomolecular film or a multimolecular film of the electron transfer protein.

An example of a structure in which the solid protein layer 13 is composed of a multimolecular film is illustrated in FIG. 2. As illustrated in FIG. 2, the solid protein layer 13 is obtained by laminating n layers (n is an integer number equal to or greater than 2) of monomolecular films that are formed from two-dimensional assembly of electron transfer proteins 13a. FIG. 2 illustrates a case of n=3.

As the electron transfer protein 13a, for example, cytochromes, iron-sulfur proteins, blue-copper proteins, and the like can be used. Examples of the cytochromes include a cytochrome c (a zinc-substituted cytochrome c, a tin-substituted cytochrome c, a metal-free cytochrome c, and the like), a cytochrome b, a cytochrome b5, a cytochrome cl, a cytochrome a, a cytochrome a3, a cytochrome f, and a cytochrome b6. Examples of the iron-sulfur proteins include rubredoxin, two-iron ferredoxin, three-iron ferredoxin, and four-iron ferredoxin. Examples of the blue-copper proteins include plastocyanin, azurin, pseudo azurin, plantacyanin, steracyanin, and amicyanin. The electron transfer protein 13a is not limited thereto. For example, a derivative of the foregoing electron transfer proteins (obtained by chemically modifying an amino-acid residue of a skeleton) or a variant thereof (obtained by substituting part of an amino-acid residue of a skeleton with other amino-acid residue) can be used. These electron transfer proteins are all water-soluble proteins.

In FIG. 1, each face on the solid protein layer 13 side of the electrodes 11 and 12 is illustrated to have a flat surface shape. However, each surface shape of the electrodes 11 and 12 is optional, and any shape such as a concave face, a convex face, and a convexoconcave face can be adopted. The flat surface shape of the non-wetted all solid protein photoelectric conversion device is selected as appropriate. Typical examples thereof include a rectangle and a square.

As a conductive material composing the electrodes 11 and 12, as described above, for example, metal, conductive glass, a conductive oxide, a conductive polymer, and the like can be used. Specifically, as the metal, for example, gold, aluminum, palladium, silver, chromium, and the like can be used. Further, as the conductive glass or the conductive oxide, for example, ITO (indium-tin composite oxide), FTO (fluorine-doped tin oxide), NESA glass ($SnO_2$ glass), and the like can be used. Further, as the conductive polymer, for example, polythiophene, polypyrrole, polyacetylene, polydiacetylene, polyparaphenylene, polyparaphenylene sulfide, and the like can be used. As the conductive polymer, a charge transfer complex (for example, TTF-TCNQ and the like) containing a tetrathiafulvalene derivative (TTF, TMTSF, BEDT-TTF, and the like) is can also be used. The electrodes 11 and 12 may be provided on a substrate made of a non-conductive material. To radiate light to all or almost all the solid protein layer 13 sandwiched between the electrodes 11 and 12, at least one of the electrodes 11 and 12 is suitably transparent to light (generally, visible light) used for light excitation of the solid protein layer 13. Specifically, the electrodes 11 and 12 are made of a conductive material transparent to the light used for light excitation such as ITO, FTO, and NESA glass, or are made of an ultrathin metal film through which light is able to be transmitted such as a gold film.

Next, a description will be given of a manufacturing method of the non-wetted all solid protein photoelectric conversion device.

First, a solution containing an electron transfer protein, which is typically a protein solution obtained by dissolving an electron transfer protein into a buffer solution containing water is attached to one of the electrodes 11 and 12, for example, to the electrode 11 by a falling drop method, a spin coat method, a dip method, a spray method, or the like.

Next, the resultant in which the protein solution is attached onto the electrode 11 is retained at room temperature or at temperature lower than room temperature. Thereby, the electron transfer protein in the attached protein solution is immobilized onto the electrode 11.

Next, the resultant in which the electron transfer protein in the protein solution is immobilized onto the electrode 11 is heated up to temperature lower than denaturation temperature of the electron transfer protein, and is subsequently dried. Thereby, all the liquid contained in the protein solution is vaporized and removed.

Accordingly, only the electron transfer protein is immobilized onto the electrode 11, and the solid protein layer 13 is formed. The thickness of the solid protein layer 13 is easily controllable by the amount of the protein solution attached onto the electrode 11, the concentration of the protein solution, and the like.

Next, the second electrode 12 is formed on the solid protein layer 13. The second electrode 12 is able to be formed by depositing a conductive material by the sputtering method, the vacuum evaporation method, or the like.

Accordingly, the intended non-wetted all solid protein photoelectric conversion device is manufactured.

Next, a description will be given of operation of the non-wetted all solid protein photoelectric conversion device. A voltage (a bias voltage) is applied between the electrode 11 and the electrode 12 of the non-wetted all solid protein photoelectric conversion device so that the electrode 12 side has a lower electric potential. In this case, the electrode 11 is a transparent electrode. In the case where light does not enter the solid protein layer 13 of the non-wetted all solid protein photoelectric conversion device, the solid protein layer 13 is insulative and a current is not flown between the electrode 11 and the electrode 12. Such a state is an off-state of the non-wetted all solid protein photoelectric conversion device. Meanwhile, as illustrated in FIG. 3, in the case where light (hu) enters the solid protein layer 13 through the electrode 11, the electron transfer proteins 13a composing the solid protein layer 13 are photo-excited, and as a result, the solid protein layer 13 becomes conductive. Accordingly, electrons (e) are flown through the solid protein layer 13 from the electrode 12 to the electrode 11, and a photocurrent is flown between the electrode 11 and the electrode 12. Such a state is an on-state of the non-wetted all solid protein photoelectric conversion device. As described above, the solid protein layer 13 behaves as a photoconductor, and enables on/off operation according to presence of light entrance to the non-wetted all solid protein photoelectric conversion device.

The foregoing state in which the solid protein layer 13 behaves as a photoconductor may result from the intramolecular electron transfer mechanism described in Non-patent document 1 and Patent document 2. That is, in the case where the electron transfer proteins 13a composing the solid protein layer 13 are photo-excited, electron transition between molecular orbitals is initiated. As a result, an electron or a hole is moved from a certain region to another region of the electron transfer proteins 13a. Such movement of the electron or the hole continuously occurs in a lot of electron transfer proteins 13a composing the solid protein layer 13. As a result, a photocurrent is flown between the electrode 11 and the electrode 12. Therefore, the electron transfer proteins 13a may be any protein basically as long as the foregoing intramolecular electron transfer mechanism works in the protein.

<Example 1>

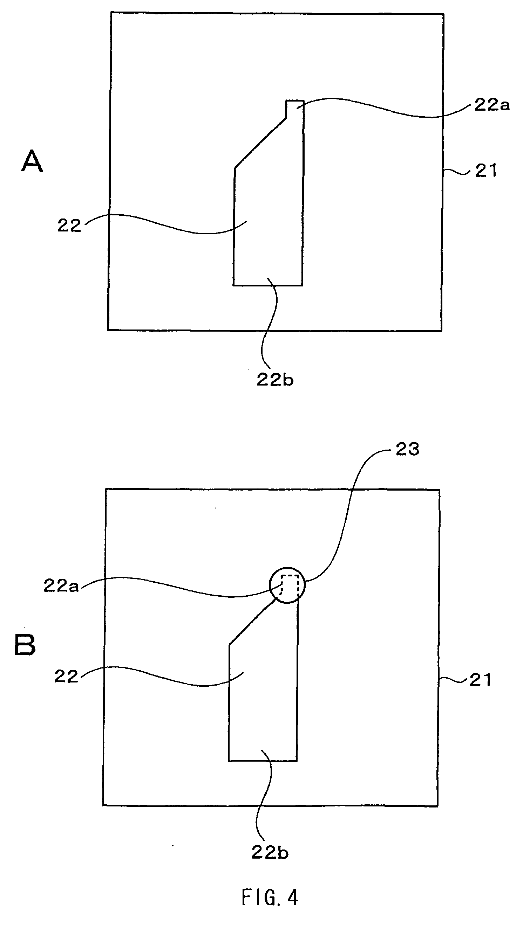

As illustrated in FIG. 4A, an ITO electrode 22 in a predetermined shape was formed as the first electrode 11 on a glass substrate 21. The thickness of the ITO electrode 22 was 100 nm, and the area thereof was 1 mm$^2$. The ITO electrode 22 was a working electrode.

Protein solutions (200 uM) obtained by respectively dissolving a zinc-substituted horse heart cytochrome c, a tin-substituted horse heart cytochrome c, a tin-substituted bovine heart cytochrome c, and a metal-free horse heart cytochrome c as an electron transfer protein in concentrated form in a Tris-HCl buffer solution (pH 8.0) were prepared. The zinc-substituted horse heart cytochrome c was obtained by substituting iron as a central metal of a heme of a horse heart cytochrome c with zinc. The tin-substituted horse heart cytochrome c was obtained by substituting iron as the central metal of the heme of the horse heart cytochrome c with tin. The tin-substituted bovine heart cytochrome c was obtained by substituting iron as a central metal of a heme of a bovine heart cytochrome c with tin. The metal-free horse heart cytochrome c was obtained by removing iron as the central metal of the heme of the bovine heart cytochrome c.

The zinc-substituted horse heart cytochrome c, the tin-substituted horse heart cytochrome c, the tin-substituted bovine heart cytochrome c, and the metal-free horse heart cytochrome c described above were prepared as follows. The horse heart cytochrome c and the bovine heart cytochrome c made by Sigma Corporation were used. A description will be mainly given of a preparation method of the tin-substituted horse heart cytochrome c. However, preparation methods of the zinc-substituted horse heart cytochrome c and the zinc-substituted bovine heart cytochrome c are similar to the preparation method of the tin-substituted horse heart cytochrome c. It is to be noted that a protein that is composed of amino-acid sequence obtained by losing, substituting, or adding one or more amino acids in the amino-acid sequence of the horse heart cytochrome c or the bovine heart cytochrome c and that contains tin or zinc is also able to be similarly prepared by using a technology such as random mutation and chemical modification as appropriate.

6 mL of 70% fluorinated acid/pyridine was added to 100 mg of horse heart cytochrome c powder, and the resultant was incubated for 10 minutes at room temperature. Thereby, iron as the central metal of the heme was removed from the horse heart cytochrome c. 9 mL of 50 mM ammonium acetate buffer solution (pH 5.0) was added to the horse heart cytochrome c from which iron was removed as described above. After reaction stopped, a metal-free horse heart cytochrome c from which the central metal was removed was obtained by gel filtration column chromatography (column cubic volume: 150 mL, resin: Sephadex G-50, developing solvent: 50 mM sodium acetate buffer solution (pH 5.0)).

The metal-free horse heart cytochrome c solution was condensed as much as possible, and glacial acetic acid was added to the resultant to obtain pH 2.5 (+/-0.05). About 25 mg of tin chloride powder was added to the obtained solution, and the resultant was incubated for 30 minutes at 50 deg C with light blocked. In the foregoing process, in a case where zinc acetate or zinc chloride was added instead of tin chloride, a zinc-substitution is obtained. Ultraviolet visible absorption spectrum was measured every 10 minutes. Incubation was continued until a ratio between an absorption peak in a wavelength of 280 nm of the protein and an absorption peak in a wavelength of 408 nm derived from tin porphyrin became constant.

All operations on and after the foregoing process were performed under light interception. After a saturated diphosphoric acid-sodium hydrogen solution was added to the foregoing solution which was finally obtained to obtain neutral pH (6.0<), buffer solution exchange to 10 mM sodium phosphate buffer solution (pH 7.0) was performed. After that, a monomeric fraction was collected by cation exchange column chromatography (column cubic volume: 40 mL, resin: SP-Sephadex Fast Flow, elution: linear concentration gradient of 10 to 150 mM sodium phosphate buffer solution (pH 7.0)). Thus, the tin-substituted horse heart cytochrome c was prepared. The tin-substituted bovine heart cytochrome c and the zinc-substituted bovine heart cytochrome c are able to be prepared similarly.

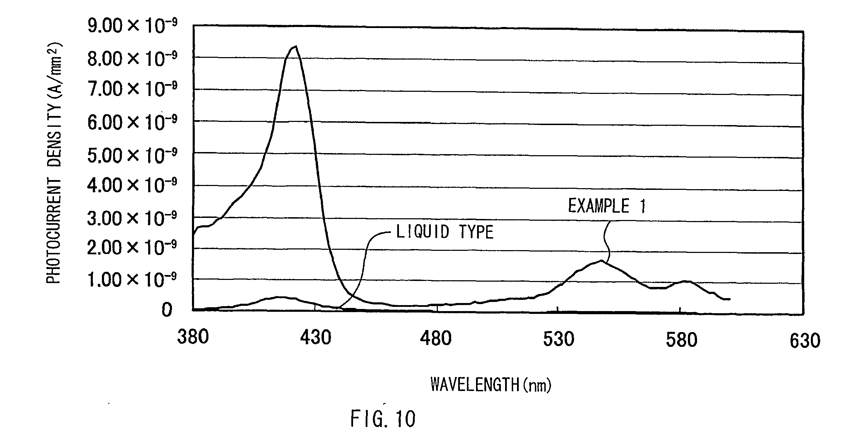

Next, as illustrated in FIG. 4B, 10 $\mu$L of the protein solutions prepared as described above was dropped onto one end 22a of the ITO electrode 22, and thereby a protein droplet 23 was attached to the ITO electrode 22. Next, the resultant was left for 2 hours at room temperature, or for a day and a night at 4 deg C, and thereby the zinc-substituted horse heart cytochrome c, the tin-substituted horse heart cytochrome c, the tin-substituted bovine heart cytochrome c, or the metal-free horse heart cytochrome c in the protein droplet 23 was immobilized onto the ITO electrode 22.

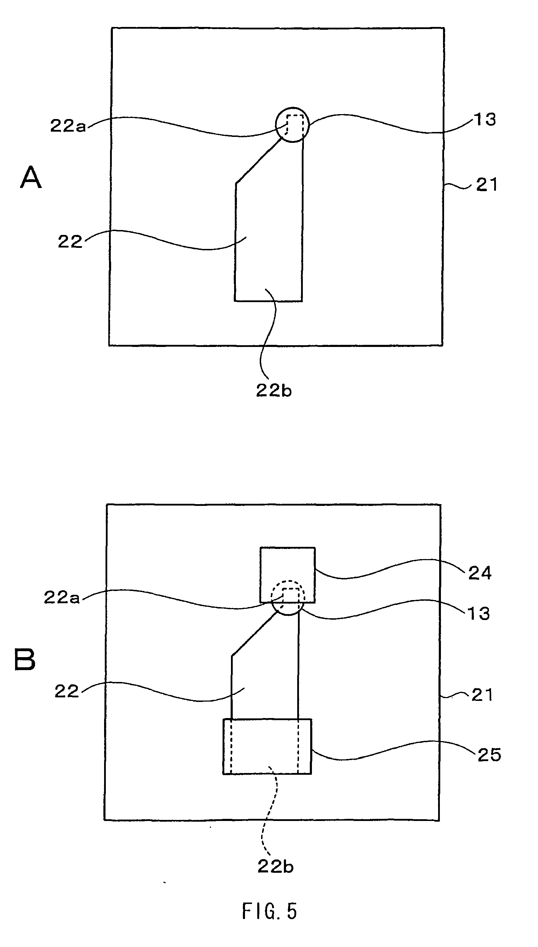

Next, the samples were put into a drier machine retained at 30 to 40 deg C both inclusive, and were dried for 30 to 60 minutes both inclusive. By such drying process, a liquid such as water contained in the protein droplet 23 was vaporized and removed. As a result, only the zinc-substituted horse heart cytochrome c, the tin-substituted horse heart cytochrome c, the tin-substituted bovine heart cytochrome c, or the metal-free horse heart cytochrome c was left on the ITO electrode 22, and the solid protein layer 13 was formed as illustrated in FIG. 5A. The thickness of the solid protein layer 13 was about 1 $\mu$.m.

Next, as illustrated in FIG. 5B, an electrode 24 was formed to overlap the solid protein layer 13, and an electrode 25 was formed to overlap the other end 22b of the ITO electrode 22. The electrode 24 was used as a counter electrode and a reference electrode. The electrodes 24 and 25 were formed from an Au film or an Al film. The thickness of the Au film was 20 nm, and the thickness of the Al film was 50 nm. The electrodes 24 and 25 were able to be formed by masking sections other than regions in which the electrodes 24 and 25 were formed and depositing an electrode material by the sputtering method or the vacuum evaporation method. The planar shapes of the electrodes 24 and 25 were a rectangle or a square.

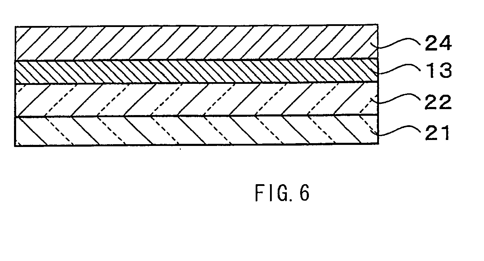

Thus, the non-wetted all solid protein photoelectric conversion device was manufactured. The cross sectional structure of the non-wetted all solid protein photoelectric conversion device is illustrated in FIG. 6.

Many non-wetted all solid protein photoelectric conversion devices were manufactured as described above, and resistance between the electrodes 24 and 25 was measured in the air. As a result, the resistance was distributed in a wide range from 1 k$\Omega$ to 30 M$\Omega$ both inclusive. The reason why the resistance between the electrodes 24 and 25 was distributed in the wide range as described above was as follows. That is, the thickness of the solid protein layer 13 varied according to each device, or each type of the electron transfer proteins 13a composing the solid protein layer 13 varied according to each device.

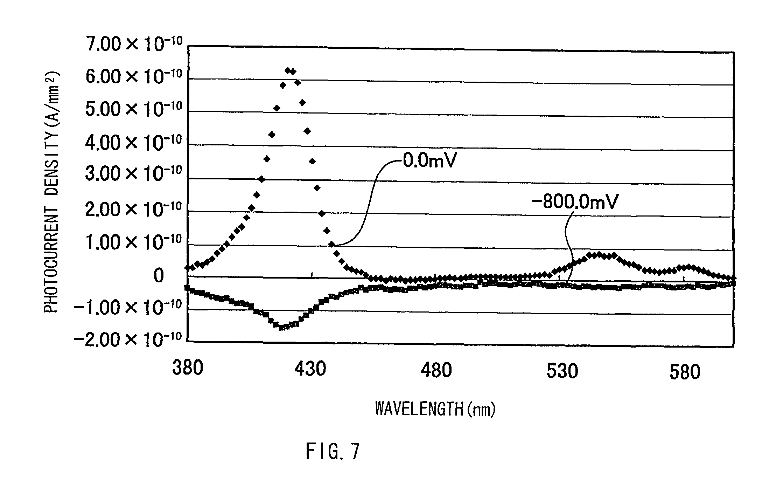

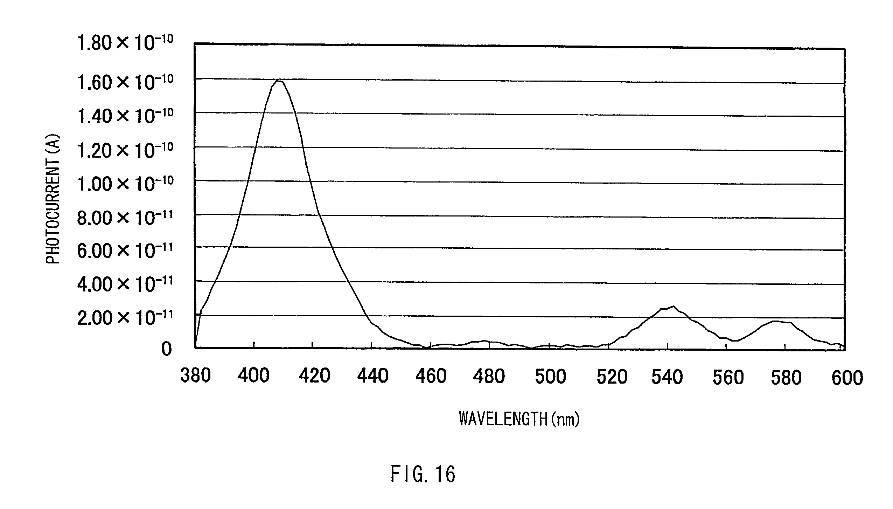

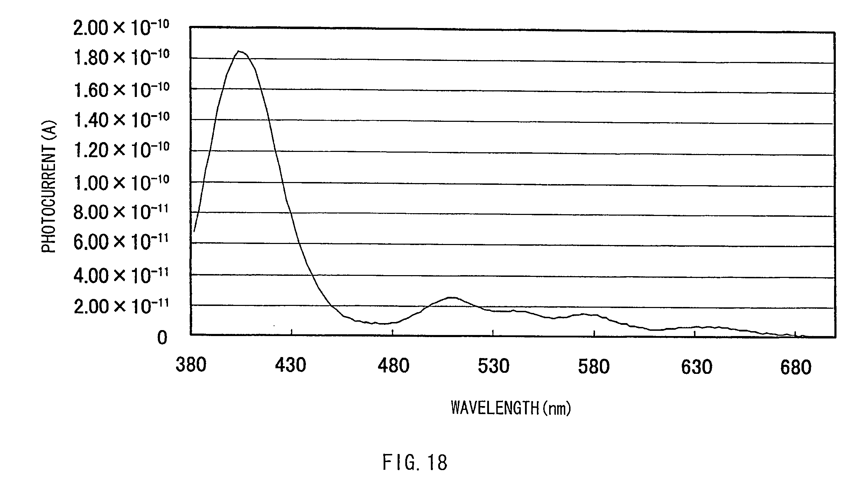

Photocurrent action spectrums of the non-wetted all solid protein photoelectric conversion device were measured. As the electron transfer proteins 13a composing the solid protein layer 13, the zinc-substituted horse heart cytochrome c, the tin-substituted bovine heart cytochrome c, and the metal-free horse heart cytochrome c were used. Measurement was performed by connecting a working electrode of a potentiostat to the electrode 25 connected to the ITO electrode 22, and connecting a counter electrode and a reference electrode to the electrode 24. The electrodes 24 and 25 were each made of an Au film being 20 nm thick. A measurement result of action spectrums under potentials of 0 mV and -800 mV for the case of using the zinc-substituted horse heart cytochrome c as the proteins 13a composing the solid protein layer 13 is illustrated in FIG. 7. Further, a measurement result of an action spectrum under a potential of 0 mV for the case of using the tin-substituted bovine heart cytochrome c as the proteins 13a composing the solid protein layer 13 is illustrated in FIG. 16. Further, a measurement result of an action spectrum under a potential of 0 mV for the case of using the metal-free horse heart cytochrome c as the proteins 13a composing the solid protein layer 13 is illustrated in FIG. 18. As illustrated in FIG. 7, FIG., 16, and FIG. 18, in the case where any of the zinc-substituted horse heart cytochrome c, the tin-substituted bovine heart cytochrome c, and the metal-free horse heart cytochrome c was used as the proteins 13a composing the solid protein layer 13, an action spectrum was able to be observed. In particular, as illustrated in FIG. 7, in the case where the zinc-substituted horse heart cytochrome c was used as the proteins 13a composing the solid protein layer 13, action spectrums in both positive and negative directions were able to be observed. Further, as illustrated in FIG. 7, the action spectrum was able to be measured even under an overvoltage of-800 mV, which was a new finding and was a significantly remarkable result.

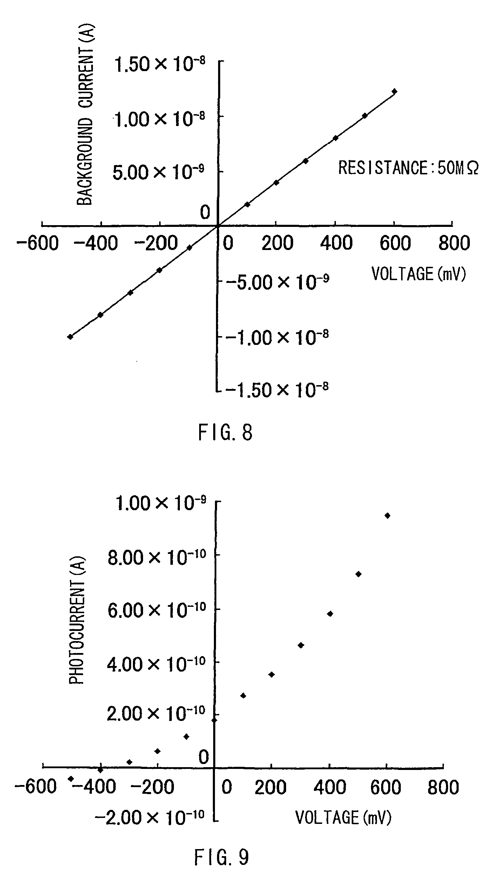

FIG. 8 illustrates a measurement result of a background current (current flown at the time of light off) at each voltage for the case of applying a voltage (a bias voltage) between the electrodes 24 and 25 of the non-wetted all solid protein photoelectric conversion device using the zinc-substituted horse heart cytochrome c as the proteins 13a composing the solid protein layer 13. As illustrated in FIG. 8, a curve indicating relation between the voltage and the background current is a straight line, which means conductivity of the solid protein layer 13 is similar to that of a semiconductor. From the slope of the straight line, it is found that resistance between the electrodes 24 and 25 is about 50 M$\Omega$.

FIG. 9 illustrates a measurement result of a photocurrent (current flown at the time of light on) at each voltage for the case of applying a voltage between the electrodes 24 and 25 of the non-wetted all solid protein photoelectric conversion device using the zinc-substituted horse heart cytochrome c as the proteins 13a composing the solid protein layer 13. As illustrated in FIG. 9, a curve indicating relation between the voltage and the photocurrent is also an approximately straight line, which means that the solid protein layer 13 functions as an photoconductor.

FIG. 10 illustrates a measurement result of photocurrent action spectrums of the non-wetted all solid protein photoelectric conversion device using the zinc-substituted horse heart cytochrome c as the proteins 13a composing the solid protein layer 13 and a liquid type protein photoelectric conversion device formed by the after-mentioned method. In FIG. 10 and FIG. 11 to FIG. 13 described below, the foregoing non-wetted all solid protein photoelectric conversion device will be abbreviated to "Example 1," and the liquid type protein photoelectric conversion device will be abbreviated to "liquid type." "

The liquid type protein photoelectric conversion device was formed as described below. First, a predetermined region on the surface of an ITO film formed on a glass substrate was masked with the use of a tape or a resin. Next, a section of the ITO film not masked was removed by wet etching for 90 seconds by using 12M HCl (50 deg C). Next, after the glass substrate was washed with water, the mask was removed, and the resultant was dried in airflow. Next, the glass substrate was subjected to ultrasonic treatment for 30 minutes in a 1% Alconox (registered trademark) aqueous solution, was subsequently subjected to ultrasonic treatment for 15 minutes in isopropanol, and was subjected to ultrasonic treatment for 15 minutes in water twice. Next, after the glass substrate was soaked in 0.01 M NaOH for 3 minutes, the resultant was dried in airflow or nitrogen flow. After that, the glass substrate was subjected to ultraviolet (UV)-ozone surface treatment for 15 minutes at about 60 deg C. Thus, the ITO electrode was formed. The ITO electrode was a working electrode. Next, in the first method, the ITO electrode formed as described above was rinsed with a protein solution (50 μM) obtained by dissolving the zinc-substituted horse heart cytochrome c in Tris-HCl buffer solution (pH 8.0). Next, after the ITO electrode rinsed with the protein solution as above was retained for a night at 4 deg C, the resultant was rinsed with water and was dried in airflow or nitrogen flow. In the second method, the ITO electrode formed as described above was rinsed with a protein solution (50 μM) obtained by dissolving the zinc-substituted horse heart cytochrome c in Tris-HCl buffer solution (pH 8.0). Otherwise, the ITO electrode formed as described above was rinsed with a protein solution (5 μM) obtained by dissolving the zinc-substituted horse heart cytochrome c in a sodium phosphate buffer solution (pH 7.0). Next, the ITO electrode rinsed with the protein solution as above was dried in vacuum. After that, the ITO electrode was rinsed with water and was dried in airflow or nitrogen flow. As described above, a protein immobilized electrode in which the protein was immobilized onto the ITO electrode was formed. Next, the protein side of the protein immobilized electrode was placed opposite to a clean ITO electrode separately formed as a counter electrode with a predetermined distance in between. Outer circumferential sections of the protein immobilized electrode and the ITO electrode were sealed with a resin. In the ITO electrode as the counter electrode, a pinhole that communicates with a space between the protein immobilized electrode and the ITO electrode was formed as an air hole. Next, the resultant obtained by sealing the outer circumferential sections of the protein immobilized electrode and the ITO electrode with the resin was soaked in an electrolyte solution contained in a container. As the electrolyte solution, a solution obtained by dissolving 0.25 mM potassium ferrocyanide in a 10 mM sodium phosphate buffer solution (pH 7.0) was used. Next, the container was retained in vacuum, and air in the space between the protein immobilized electrode and the ITO electrode was ejected outside from the foregoing pinhole. Next, the container was returned back under atmosphere pressure, and the space between the protein immobilized electrode and the ITO electrode was filled with the electrolyte solution. After that, the foregoing pinhole was sealed with a resin. Accordingly, the liquid type protein photoelectric conversion device was formed.

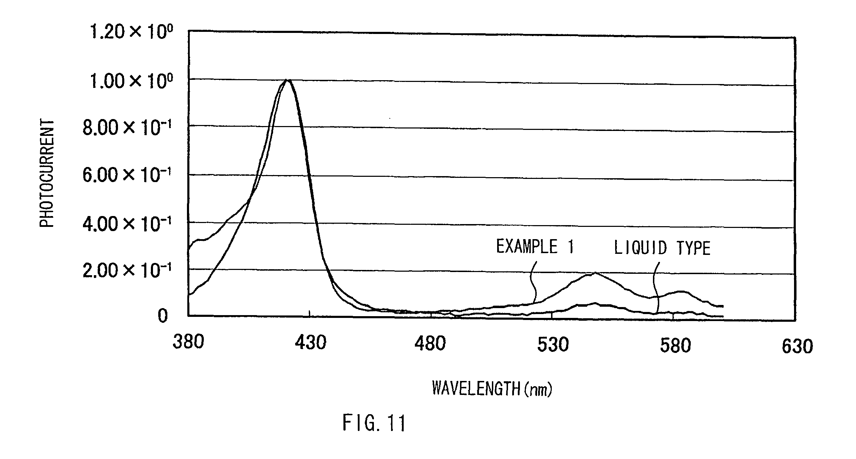

FIG. 11 is a graph obtained by standardizing the spectrums of the non-wetted all solid protein photoelectric conversion device and the liquid type protein photocurrent conversion device illustrated in FIG. 10 so that the photocurrent density of the peak in the vicinity of a wavelength of 420 nm is 1. As illustrated in FIG. 11, the respective photocurrent densities of both spectrums differ from each other. However, each peak wavelength in Soret band in the vicinity of a wavelength of 423 nm and Q band in the vicinity of a wavelength of 550 nm and a wavelength of 583 nm is identical. Thus, it is found that in both cases, a photocurrent derived from the zinc-substituted horse heart cytochrome c was obtained. The inventors were the first finders who found the fact that the photocurrent derived from the zinc-substituted horse heart cytochrome c was obtained in the non-wetted all solid protein photoelectric conversion device using the solid protein layer 13 composed of the zinc-substituted horse heart cytochrome c. The finding is an amazing result that defies existing common sense.

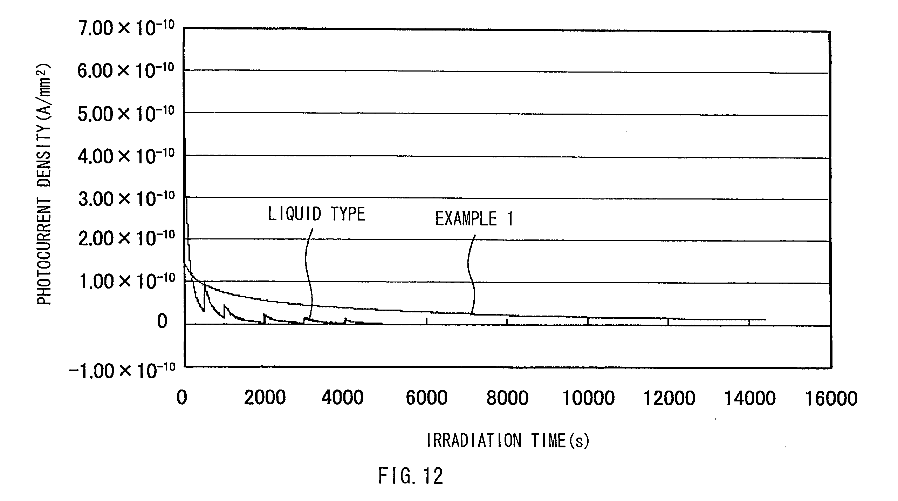

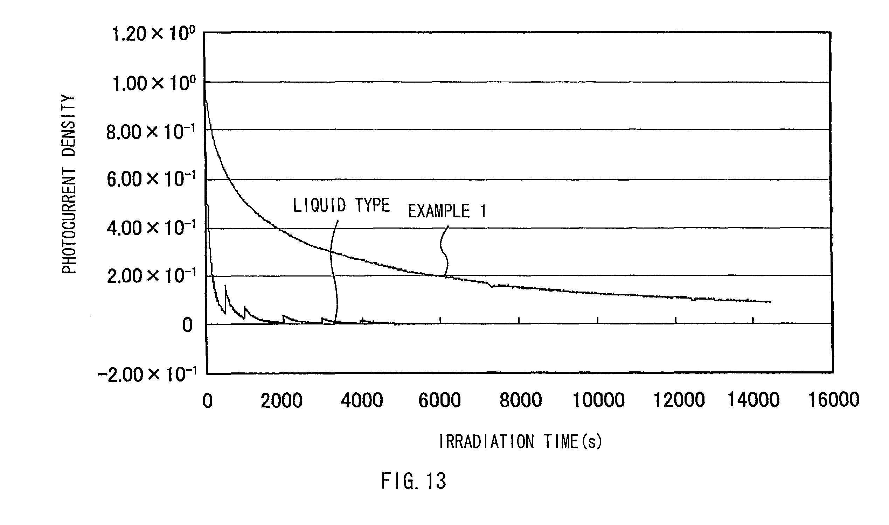

FIG. 12 illustrates a measurement result of light degradation curves (curves indicating decrease of photocurrent density to light irradiation time) for the foregoing non-wetted all solid protein photoelectric conversion device and the foregoing liquid type protein photoelectric conversion device. The measurement was performed by measuring photocurrent density while irradiating the non-wetted all solid protein photoelectric conversion device and the liquid type protein photoelectric conversion device with laser light having a wavelength of 405.5 nm at an intensity of 0.2 mW/mm$^2$. The irradiation intensity of the laser light was as high as 0.2 mW/mm$^2$ in order to increase light degradation rate and shorten test time. FIG. 13 is a graph obtained by standardizing the light degradation curves of the non-wetted all solid protein photoelectric conversion device and the liquid type protein photoelectric conversion device illustrated in FIG. 12 so that the photocurrent density at the time of the irradiation time 0 becomes 1.

The light degradation curves illustrated in FIG. 13 were provided with fitting with the use of the following function.

$$f(x) = a * e * p (b * x) + c * e * p (d * x)$$

Coefficients a, b, c, and d of the function f(x) are as follows. Numerical values in parentheses of each coefficient indicate 95% confidence interval.

Liquid type protein photoelectric conversion device

a=5.204 x 10<sup>-9</sup> (5.029 x 10<sup>-9</sup>, 5.378 x 10<sup>-9</sup>)
b=-0.00412 (-0.00441, -0.003831)
c=1.799 x 10<sup>-10</sup> (2.062 x 10<sup>-11</sup>, 3.392 x 10<sup>-10</sup>)
d=-0.0004618 (-0.0008978, -2.58 x 10<sup>-5</sup>)

Non-wetted all solid protein photoelectric conversion device

a=5.067 x 10<sup>-11</sup>(4.883 x 10<sup>-11</sup>, 5.251 x 10<sup>-11</sup>)
b=-0.0009805 (-0.001036, -0.0009249)
c=4.785 x 10<sup>-11</sup> (4.58 x 10<sup>-11</sup>, 4.99 x 10<sup>-11</sup>)
d=-0.0001298 (-0.0001374, -0.0001222)

Life t of the non-wetted all solid protein photoelectric conversion device and the liquid type protein photoelectric conversion device is defined as $t=[a/(a+c)](-1/b)+[c/(a+c)](-1/d)$. According to the definition, the life of the liquid type protein photoelectric conversion device is 306 seconds, while the life of the non-wetted all solid protein photoelectric conversion device is 4266 seconds. Thus, it is found that the life of the non-wetted all solid protein photoelectric conversion device is at least 14 times as much as the life of the liquid type protein photoelectric conversion device.
It is to be noted that, in the light degradation curve of the liquid type protein photoelectric conversion device illustrated in FIG. 13, a saw-like waveform is shown for the following reason. That is, the measurement needed to be interrupted in order to remove oxygen generated in the electrolyte solution. After operation of removing oxygen, a photocurrent is slightly increased.
Next, a description will be given of results of measuring frequency response of the non-wetted all solid protein photoelectric conversion device and the liquid type protein photoelectric conversion device.

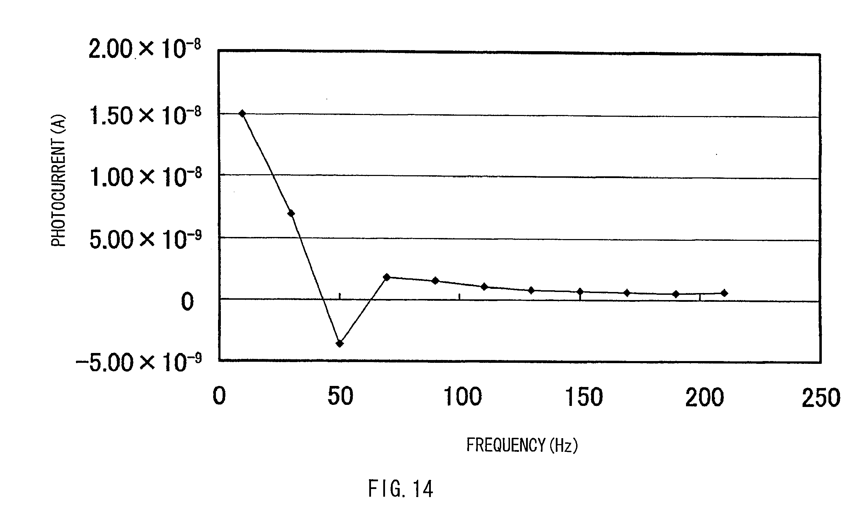

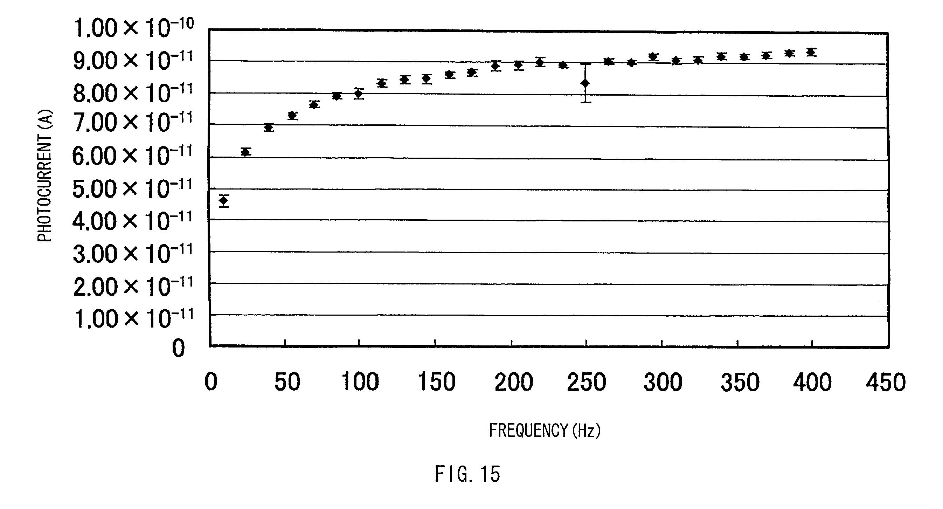

FIG. 14 illustrates a measurement result of the frequency response of the liquid type protein photoelectric conversion device, and FIG. 15 illustrates a measurement result of the frequency response of the non-wetted all solid protein photoelectric conversion device. From FIG. 14 and FIG. 15, it is found that 3dB bandwidth (frequency at which a photocurrent value became 50% as much as the maximum photocurrent value) of the liquid type protein photoelectric conversion device is lower than 30 Hz, while 3dB bandwidth of the non-wetted all solid protein photoelectric conversion device is 400 Hz or more. Accordingly, it is found that the response rate of the non-wetted all solid protein photoelectric conversion device is at least 13 times as much as the response rate of the liquid type protein photoelectric conversion device.

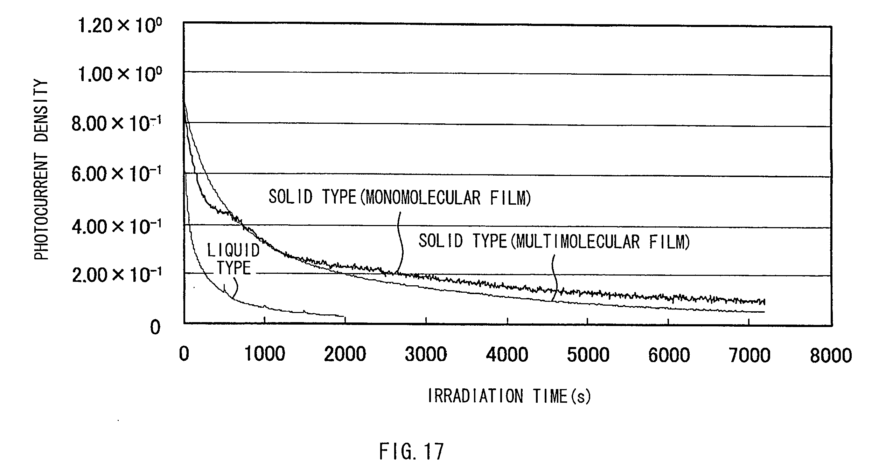

FIG. 17 is a graph obtained by measuring light degradation curves for the non-wetted all solid protein photoelectric conversion device using the tin-substituted bovine heart cytochrome c as the proteins 13a composing the solid protein layer 13 and the liquid type protein photoelectric conversion device using the tin-substituted bovine heart cytochrome c and standardizing the light degradation curves so that the photocurrent density at the time of the irradiation time of 0 becomes 1. A formation method of the liquid type protein photoelectric conversion device was similar to the foregoing method, except that the tin-substituted bovine heart cytochrome c was used instead of the zinc-substituted horse heart cytochrome c. As the non-wetted all solid protein photoelectric conversion device, a device having a monomolecular film of the tin-substituted bovine heart cytochrome c and a device having a multimolecular film of the tin-substituted bovine heart cytochrome c were formed. The measurement was performed by measuring photocurrent density while irradiating the non-wetted all solid protein photoelectric conversion device and the liquid type protein photoelectric conversion device with laser light having a wavelength of 405.5 nm at an intensity of 0.2 mW/mm<sup>2</sup>. The irradiation intensity of the laser light was as high as 0.2 mW/mm<sup>2</sup> in order to increase light degradation rate and shorten test time.
The light degradation curves illustrated in FIG. 17 were provided with fitting with the use of the following function.

$$f(x)=a * e * p (b * x)+c * e * p (d * x)$$

Coefficients a, b, c, and d of the function f(x) are as follows.
Liquid type protein photoelectric conversion device

a=1.72 x 10<sup>-8</sup>

b=-0.00462

c=3.51 x 10<sup>-9</sup>

d=-0.000668

Non-wetted all solid protein photoelectric conversion device (monomolecular film)

a=0.4515
b=-0.002599
c=0.3444
d=-0.0001963

Non-wetted all solid protein photoelectric conversion device (multimolecular film)

a=0.5992
b=-0.002991
c=0.2371
d=-0.0001513

In this case, light degradation average time constants of the non-wetted all solid protein photoelectric conversion device and the liquid type protein photoelectric conversion device were as follows.
Liquid type protein photoelectric conversion device: $2.54 \times 10^2$ seconds
Non-wetted all solid protein photoelectric conversion device (monomolecular film): $2.71 \times 10^3$ seconds
Non-wetted all solid protein photoelectric conversion device (multimolecular film): $2.73 \times 10^3$ seconds
As in the foregoing description, the life t of the non-wetted all solid protein photoelectric conversion device and the liquid type protein photoelectric conversion device is defined as t=[a/(a+c)](-1/b)+[c/(a+c)](-1/d). According to the definition, the life of the liquid type protein photoelectric conversion device is 434 seconds, while the life of the non-wetted all solid protein photoelectric conversion device (monomolecular film) is 2423 seconds and the life of the non-wetted all solid protein photoelectric conversion device (multimolecular film) is 2113 seconds. Thus, it is found that the life of the non-wetted all solid protein photoelectric conversion device is at least about 5 times as much as the life of the liquid type protein photoelectric conversion device.

<Example 2>

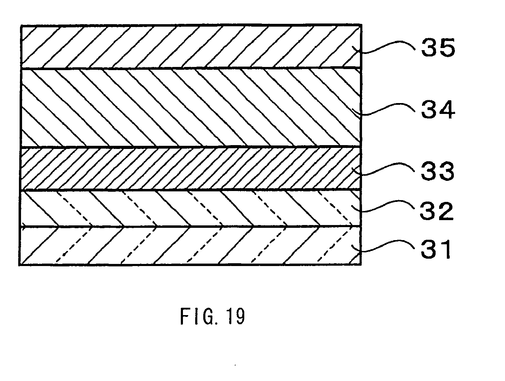

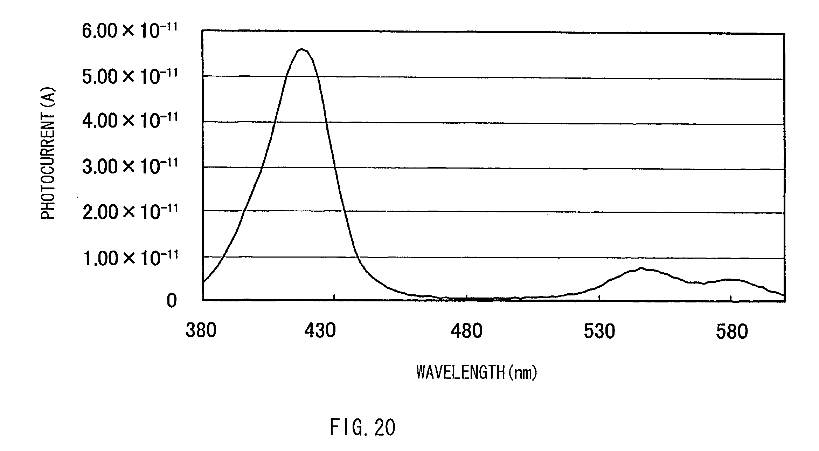

As illustrated in FIG. 19, an ITO electrode 32 in a predetermined shape was formed as the first electrode 11 on a glass substrate 31. The thickness of the ITO electrode 32 was 100 nm, and the area thereof was 1 mm². The ITO electrode 32 was a working electrode.
Next, a solid protein layer 33 composed of a monomolecular film of the zinc-substituted horse heart cytochrome c and a solid protein layer 34 composed of a multimolecular film of blue copper protein azurin were sequentially formed on the ITO electrode 32. The solid protein layer 33 is a light-sensitive layer, and the solid protein layer 34 is a carrier transport layer. The forming methods of the solid protein layers 33 and 34 are similar to that of Example 1.
Next, an Au film 35 was formed as the second electrode 12 on the solid protein layer 34. The thickness of the Au film 35 was 20 nm.
A measurement result of a photocurrent action spectrum of the non-wetted all solid protein photoelectric conversion device fabricated as above is illustrated in FIG. 20. As illustrated in FIG. 20, as in Example 1, a spectrum having Soret band in the vicinity of a wavelength of 423 nm and Q band in the vicinity of a wavelength of 550 nm and a wavelength of 583 nm is obtained. Thus, it is found that a photocurrent derived from the zinc-substituted horse cytochrome c is obtained. Accordingly, it is evident that the solid protein layer 34 composed of the multimolecular film of azurin behaves as a photoconductor and functions as a carrier transport layer.

<Example 3>

As illustrated in FIG. 20, an ITO electrode 42 in a predetermined shape was formed as the first electrode 11 on a glass substrate 41. The thickness of the ITO electrode 42 was 100 nm, and the area thereof was 1 mm². The ITO electrode 42 was a working electrode.
Next, a solid protein layer 43 composed of a monomolecular film of the zinc-substituted horse heart cytochrome c and a solid protein layer 44 composed of a multimolecular film of a horse heart cytochrome c having iron as a central metal were sequentially formed. Here, the solid protein layer 43 is a light-sensitive layer, and the solid protein layer 44 is a carrier transport layer. The forming methods of the solid protein layers 43 and 44 are similar to that of Example 1.
Next, an Au film 45 was formed as the second electrode 12 on the solid protein layer 44. The thickness of the Au film 45 was 20 nm.

A photocurrent action spectrum of the non-wetted all solid protein photoelectric conversion device fabricated as above was measured. As in Example 1, a spectrum having Soret band in the vicinity of a wavelength of 423 nm and Q band in the vicinity of a wavelength of 550 nm and a wavelength of 583 nm was obtained, and a photocurrent derived from the zinc-substituted horse cytochrome c was obtained. Accordingly, it was confirmed that the solid protein layer 44 composed of the multimolecular film of the horse heart cytochrome c having iron as a central metal behaved as a photoconductor and functioned as a carrier transport layer.

According to the non-wetted all solid protein photoelectric conversion device according to the embodiment, the following various advantages are able to be obtained. That is, the non-wetted all solid protein photoelectric conversion device does not include water inside the device, and is operable without being contacted with water. Thus, as a photoelectric conversion device replacing the existing photoelectric conversion device using a semiconductor, the non-wetted all solid protein photoelectric conversion device is able to be mounted onto an electronic device. Further, in the non-wetted all solid protein photoelectric conversion device, since water does not exist inside the device, heat denaturation, radical damage, decay, and the like of an electron transfer protein resulting from the existence of water are able to be prevented, stability is high, and durability is superior. Further, in the non-wetted all solid protein photoelectric conversion device, since water does not exist inside and outside the device, there is no possibility of electric shock, and intensity is easily secured.

Further, in the non-wetted all solid protein photoelectric conversion device, the solid protein layer 13 is directly immobilized onto the electrodes 11 and 12 without a linker molecule or the like in between. Thus, compared to a case that the non-wetted all solid protein photoelectric conversion device is immobilized onto the electrodes 11 and 12 with the linker molecule or the like in between, a larger photocurrent is able to be obtained. Further, in addition to the fact that the solid protein layer 13 is directly immobilized onto the electrodes 11 and 12, the solid protein layer 13 is able to be formed significantly thinly. Thus, the distance between the electrode 11 and the electrode 12 is able to be significantly shortened. Thus, the non-wetted all solid protein photoelectric conversion device is able to be formed thinly. In addition, by transparentizing the electrodes 11 and 12, a plurality of the non-wetted all solid protein photoelectric conversion devices are able to be laminated and used. Further, in the non-wetted all solid protein photoelectric conversion device, the size of the electron transfer protein 13a composing the solid protein layer 13 is significantly small, about 2 nm. Thus, for example, it is possible to significantly precisely detect light entrance position in the solid protein layer 13. Thus, a high-definition optical sensor or a high-definition image capturing device is able to be realized.

Further, it is presumed that, in the case where, for example, the zinc-substituted horse heart cytochrome c is used as the electron transfer protein 13a, a photo conductive effect of the zinc-substituted horse heart cytochrome c results from "one photon multielectron generation." However, in the liquid type protein photoelectric conversion device, since resistance of the solution (solution resistance) existing between the electrodes is high, the foregoing "one photon multielectron generation" is possibly prevented. Meanwhile, in the non-wetted all solid protein photoelectric conversion device, since the solution resistance does not exist, "one photon multielectron generation" is enabled, photoelectric conversion efficiency is able to be significantly improved, and a higher photocurrent is able to be obtained.

The non-wetted all solid protein photoelectric conversion device is able to realize an optical switching device, an optical sensor, an image capturing device and the like. As described above, since the frequency response of the non-wetted all solid protein photoelectric conversion device is fast, the non-wetted all solid protein photoelectric conversion device is able to realize an optical switching device capable of performing high-speed switching, a high-speed response optical sensor, an image capturing device capable of capturing an object moving at a high speed, and the like. Further, in the case where the non-wetted all solid protein photoelectric conversion device is used for the optical switching device, the optical sensor, the image capturing device, and the like, a superior electronic device is able to be realized.

The embodiment and the examples of the present invention have been specifically described. However, the present invention is not limited to the foregoing embodiment and the foregoing Examples, and various modifications may be made based on the technical idea of the present invention.

For example, the numerical values, the structures, the configurations, the shapes, the materials, and the like described in the foregoing embodiment and the foregoing Examples are only examples. Numerical values, structures, configurations, shapes, materials, and the like different from those described in the foregoing embodiment and the foregoing Examples are able to be used as appropriate.

## Claims

1. A non-wetted all solid protein photoelectric conversion device, comprising a structure in which a solid protein layer composed of an electron transfer protein is sandwiched between a first electrode and a second electrode.

2. The non-wetted all solid protein photoelectric conversion device according to claim 1, wherein the solid protein layer is composed of a monomolecular film or a multimolecular film of the electron transfer protein.

**3.** The non-wetted all solid protein photoelectric conversion device according to claim 2, wherein at least one of the first electrode and the second electrode is a transparent electrode made of a material transparent to visible light.

**4.** The non-wetted all solid protein photoelectric conversion device according to claim 3, wherein the solid protein layer is directly immobilized onto the first electrode and the second electrode.

**5.** The non-wetted all solid protein photoelectric conversion device according to claim 1, wherein the non-wetted all solid protein photoelectric conversion device is an optical switching device.

**6.** The non-wetted all solid protein photoelectric conversion device according to claim 1, wherein the non-wetted all solid protein photoelectric conversion device is an optical sensor.

**7.** A method of manufacturing a non-wetted all solid protein photoelectric conversion device comprising:

attaching a solution containing an electron transfer protein to at least part of a first electrode;
forming a solid protein layer composed of the electron transfer protein by drying the first electrode to which the solution is attached and removing a solvent of the solution; and
forming a second electrode on the solid protein layer.

**8.** The method of manufacturing a non-wetted all solid protein photoelectric conversion device according to claim 7, wherein the solvent of the solution is removed by drying the first electrode coated with the solution at temperature lower than denaturation temperature of the electron transfer protein.

**9.** The method of manufacturing a non-wetted all solid protein photoelectric conversion device according to claim 8, wherein the second electrode is formed on the solid protein layer by a sputtering method or a vacuum evaporation method.

**10.** The method of manufacturing a non-wetted all solid protein photoelectric conversion device according to claim 9, wherein the solid protein layer is composed of a monomolecular film or a multimolecular film of the electron transfer protein.

**11.** The method of manufacturing a non-wetted all solid protein photoelectric conversion device according to claim 10, wherein at least one of the first electrode and the second electrode is a transparent electrode made of a material transparent to visible light.

**12.** An electronic device, comprising a non-wetted all solid protein photoelectric conversion device having a structure in which a solid protein layer composed of an electron transfer protein is sandwiched between a first electrode and a second electrode.

FIG. 1

FIG. 2

FIG. 3

A

22a

21

22

22b

B

23

22a

22

21

22b

FIG. 4

14

A

22a ⌇ 13

21

22

22b

B

24

22a 13

21

22

25

22b

FIG. 5

24

13

22

21

FIG. 6

FIG. 7

FIG. 8

FIG. 9

FIG. 10

EP 2 472 626 A1

FIG. 11

FIG. 12

FIG. 13

FIG. 14

F I G. 15

FIG. 16

FIG. 17

EP 2 472 626 A1

FIG. 18

FIG. 19

FIG. 20

EP 2 472 626 A1

FIG. 21

## INTERNATIONAL SEARCH REPORT

| | International application No. |
|---|---|
| | PCT/JP2010/063470 |

A. CLASSIFICATION OF SUBJECT MATTER
*H01L51/42*(2006.01)i, *H01L27/146*(2006.01)i, *H01M14/00*(2006.01)i

According to International Patent Classification (IPC) or to both national classification and IPC

B. FIELDS SEARCHED

Minimum documentation searched (classification system followed by classification symbols)
H01L51/42, H01L27/146, H01M14/00

Documentation searched other than minimum documentation to the extent that such documents are included in the fields searched
Jitsuyo Shinan Koho      1922–1996    Jitsuyo Shinan Toroku Koho    1996–2010
Kokai Jitsuyo Shinan Koho    1971–2010    Toroku Jitsuyo Shinan Koho    1994–2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2-281770 A (Director General, Agency of Industrial Science and Technology), 19 November 1990 (19.11.1990), column of "Example"; fig. 1 (Family: none) | 1-12 |
| X | JP 8-111095 A (Hitachi, Ltd.), 30 April 1996 (30.04.1996), paragraphs [0007], [0015] to [0016]; fig. 1 (Family: none) | 1-12 |
| X | JP 63-237585 A (Mitsubishi Electric Corp.), 04 October 1988 (04.10.1988), page 3, lower column; fig. 1 (Family: none) | 1-2,5-6,12 |

☒   Further documents are listed in the continuation of Box C.      ☐   See patent family annex.

| | | |
|---|---|---|
| * | Special categories of cited documents: | "T"   later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X"   document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"   document member of the same patent family |

| Date of the actual completion of the international search | Date of mailing of the international search report |
|---|---|
| 20 August, 2010 (20.08.10) | 31 August, 2010 (31.08.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2010/063470

C (Continuation).    DOCUMENTS CONSIDERED TO BE RELEVANT

| Category* | Citation of document, with indication, where appropriate, of the relevant passages | Relevant to claim No. |
|---|---|---|
| A | JP 6-291303 A  (Suntory Ltd.),<br>18 October 1994 (18.10.1994),<br>paragraph [0015]<br>(Family: none) | 1-12 |

Form PCT/ISA/210 (continuation of second sheet) (July 2009)

**EP 2 472 626 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2007220445 A

• JP 2009021501 A

**Non-patent literature cited in the description**

• **Tokita Y.** *J. Am. Chem. Soc.,* 2008, vol. 130, 5302